# EUROPÄISCHE PATENTSCHRIFT

(11) **EP 0 723 136 B1**
(45) Veröffentlichungstag und Bekanntmachung des Hinweises auf die Patenterteilung: **04.03.1998**
(21) Anmeldenummer: 95117391.3
(22) Anmeldetag: 04.11.1995
(51) Int. Cl.: G01D 5/16, G01D 5/14, H03M 1/12

(54) **Messeinrichtung für einen Drehwinkel**
Measuring arrangement for measuring rotation angle
Dispositif de mesure de l'angle de rotation

(30) Priorität: 20.01.1995 DE 19501617
(43) Veröffentlichungstag der Anmeldung: 24.07.1996
(73) Patentinhaber: MAX STEGMANN Gmbh ANTRIEBSTECHNIK - ELEKTRONIK, D-78166 Donaueschingen (DE)
(72) Erfinder: Siraky, Josef, D-78166 Donaueschingen (DE)
(74) Vertreter: Patentanwälte Westphal, Buchner, Mussgnug Neunert, Göhring

(56) Entgegenhaltungen:
- US-A- 4 757 244
- US-A- 4 764 767
- PATENT ABSTRACTS OF JAPAN vol. 11, no. 147 (P-575), 14.Mai 1987 & JP-A-61 283802 (TOSHIBA MACH CO LTD), 13.Dezember 1986,

## Beschreibung

Die Erfindung betrifft ein Gerät zur Bestimmung eines drehwinkelabhängigen Meßwertes gemäß dem Oberbegriff des Anspruchs 1.

Bei einem aus der DE 29 07 797 C2 bzw. DE 29 08 599 A1 bekannten Gerät dieser Gattung ist auf der Mantelfläche des trommelförmigen Rotors ein magnetisches Medium hoher Koerzitivkraft aufgebracht. Dieses Medium dient zur Aufzeichnung magnetischer Winkelinformationen, die mittels eines feststehend angeordneten Magnetfeld-Sensors ausgelesen werden.

Bei diesem bekannten Gerät wird die Schicht des magnetischen Mediums entweder als platierter Film aus der magnetischen Legierung oder in Form feiner magnetischer Partikel unter Verwendung eines Bindemittels auf der Mantelfläche des Rotors aufgebracht. Das Aufbringen magnetischer Partikel mit einem Bindemittel ist technisch aufwendig. Das Aufbringen eines Filmes hat eine auf einer axialen Mantellinie durchgehende Stoßfuge des Filmes zur Folge, die zu Störungen in der Aufzeichnung und im Auslesen der Winkelinformationen führen kann.

Aus der US-A-4 764 767 ist ein Gerät zur Bestimmung eines drehwinkelabhängigen Meßwertes bekannt, bei welchem auf der Mantelfläche eines trommelförmigen Rotors Muster von magnetischen und nichtmagnetischen Bereichen angeordnet sind. Diese Muster werden durch Sensoren abgetastet, wobei die sich ändernde Überlappung des Sensors mit den magnetischen Bereichen die Winkelinformation erzeugt. Aus der US-A-4 757 244 und der JP-A-61 283 802 sind Geräte zur Bestimmung eines linearen Weg-Meßwertes bekannt, bei welchen auf der Mantelfläche eines Stabes schraubenlinienförmig ein magnetisches Band gewickelt ist. Zwischen den Windungen des Bandes befindet sich jeweils ein nichtmagnetischer Abstandsbereich. Sensoren tasten den Wechsel zwischen magnetischen und nichtmagnetischen Bereichen bei der Linearverschiebung des Stabes ab. Bei diesen bekannten Geräten wird jeweils der Wechsel zwischen magnetischen und nichtmagnetischen Bereichen auf der Mantelfläche abgetastet, um die Meßwert-Information zu erzeugen. Es ist keine geschlossene Schicht eines magnetischen Mediums auf der Mantelfläche vorgesehen, die zur Aufzeichnung magnetischer Winkelinformationen dient.

Der Erfindung liegt die Aufgabe zugrunde, das Gerät der eingangs genannten Gattung so zu verbessern, daß bei kostengünstiger Herstellung der magnetischen Beschichtung ein störungsfreies Aufzeichnen und Auslesen der magnetischen Winkelinformationen gewährleistet ist.

Diese Aufgabe wird erfindungsgemäß gelöst durch ein Gerät mit den Merkmalen des Anspruchs 1.

Vorteilhafte Ausführungen der Erfindungen sind in den abhängigen Ansprüchen angegeben.

Der Erfindung liegt die Idee zugrunde, die magnetische Schicht auf die Mantelfläche des Rotors dadurch aufzubringen, daß ein Band oder ein Draht aus dem magnetischen Medium schraubenlinienförmig auf den Rotor gewickelt wird, wobei die Schraubenachse mit der Rotorachse zusammenfällt. Es kann somit in technisch einfacher und kostengünstiger Weise eine Schicht des magnetischen Mediums aufgebracht werden, die eine hohe Konstanz der Schichtdicke und der magnetischen Eigenschaften aufweist. Die aus dem schraubenlinienförmig gewickelten Band oder Draht bestehende Schicht weist in Umfangsrichtung keine Unterbrechung durch Stoßfugen auf, die zu Störungen beim Aufzeichnen oder Auslesen der magnetischen Winkelinformationen führen könnten. Die Berührungsfuge, die zwischen den einzelnen Windungen des Bandes oder Drahtes entsteht, verursacht keine Störungen der magnetischen Winkelinformation, da die axiale Spurbreite der aufgezeichneten Winkelinformationen und entsprechend die axiale Spurbreite des auslesenden Magnetfeld-Sensors wesentlich größer sind als die axiale Breite der Berührungsfuge zwischen den Windungen des Bandes bzw. Drahtes.

Beispielsweise kann die Spurbreite der aufgezeichneten Winkelinformationen und entsprechend die Spurbreite des abtastenden Magnetfeld-Sensors etwa 3 mm betragen. Die Berührungsfuge zwischen den einzelnen Windungen des Drahtes oder Bandes kann ohne größeren technischen Aufwand kleiner als etwa 0,1 mm gehalten werden. Die Berührungsfuge beträgt somit weniger als 3% der Spurbreite. Die Berührungsfuge bewirkt auf diese Weise zwar eine Amplitudenschwächung des erhaltenen Winkelsignals, diese Schwächung ist jedoch so gering, daß sie in der Praxis bedeutungslos ist.

Ist eine größere Amplitude des magnetischen Signals erforderlich, so kann die Schichtdicke des aufgewickelten magnetischen Mediums in einfacher Weise verstärkt werden, indem ein Draht oder ein Band größerer Stärke verwendet wird. In einer vorteilhaften Ausführung kann dagegen auch ein Band oder ein Draht geringerer Stärke in zwei oder auch mehr Lagen übereinander gewickelt werden. Vorzugsweise sind die einzelnen Lagen dabei gegenläufig gewickelt, so daß jeweils eine rechts und eine links gewickelte Lage übereinander zum Liegen kommen. Dadurch kreuzen sich die Berührungsfugen der Windungen der einzelnen Lagen und eine größere Homogenität der magnetischen Schicht entsteht.

Die spezielle Form des trommelförmigen Rotors spielt für die Erfindung eine untergeordnete Rolle. In der Regel wird der Rotor als gerader Kreiszylinder ausgebildet sein. Es sind jedoch auch andere Rotorformen möglich, z.B. kegelförmige oder ballige Rotoren und auch Rotoren mit unrundem Querschnitt. Die Form des Rotors hat auf das schraubenlinienförmige Aufwickeln des Bandes oder Drahtes aus dem magnetischen Werkstoff keinen Einfluß. Es ist lediglich eine entsprechende Anordnung und Führung des abtastenden Magnetfeld-Sensors notwendig.

Die Winkelinformationen können beliebiger an sich bekannter Art sein. Es können beispielsweise in Umfangsrichtung sinusförmig oder rechteckförmig verlaufende Informationssignale aufgezeichnet sein. Die Winkelinformationen können eine absolute Winkelcodierung oder inkrementale Winkelsignaledarstellen. Die Winkelinformationen können in einer Spur enthalten sein oder es können mehrere in Axialrichtung nebeneinander angeordnete Spuren vorgesehen sein, die sich zu einer aus mehreren Bits zusammengesetzten Winkelinformation ergänzen.

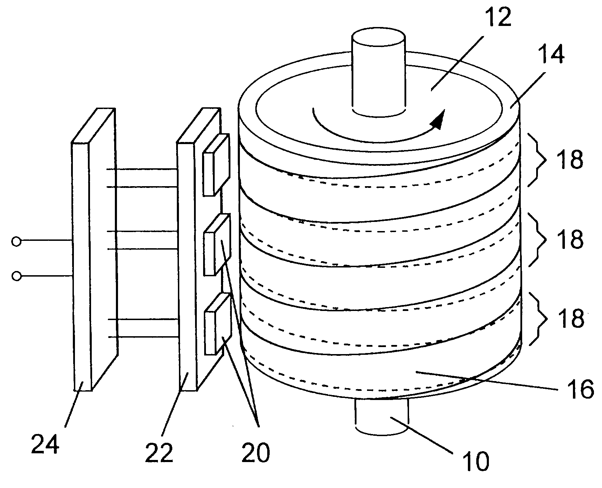

Im folgenden wird die Erfindung anhand eines in der Zeichnung dargestellten Ausführungsbeispiels näher erläutert. Die einzige Figur zeigt schematisch ein Gerät gemäß der Erfindung. Auf einer Welle 10, die zum Beispiel die Welle eines Motors ist oder mit der Welle eines Motors gekuppelt ist, sitzt ein Rotor 12 in Form eines geraden Kreiszylinders. Auf der Mantelfläche des Rotors 12 ist eine Schicht 14 eines magnetischen Mediums aufgebracht. Die Schicht 14 ist durch ein Band 16 aus einem magnetischen Werkstoff hoher Koerzitivkraft gebildet, zum Beispiel aus einer CO-P- oder CO-NI-P-Legierung. Das Band 16 ist schraubenlinienförmig auf den Mantelumfang des Rotors 12 gewickelt, wobei die Windungen des Bandes 16 dicht aneinander anliegen.

Die axiale Breite des Bandes 16, d. h. die Breite parallel zur Achse des Rotors 12 gemessen, beträgt beispielsweise 15 mm. Die axiale Breite der Berührungsfuge zwischen den einzelnen einander anliegenden Windungen des Bandes 16 ist kleiner als 0,1 mm.

Auf die durch das schraubenlinienförmig gewickelte Band 16 gebildete Schicht 14 werden magnetische Winkelinformationen aufgebracht. Diese Winkelinformationen sind in Spuren 18 angeordnet, die ringförmig in Umfangsrichtung verlaufen. Die Spuren 18 sind axial aufeinanderfolgend angeordnet. In dem Ausführungsbeispiel sind drei Spuren 18 dargestellt, die in der Zeichnung durch gestrichelte Linien begrenzt sind. Die axiale Breite der Spuren 18, d. h. die Breite parallel zur Achse des Rotors 12 gemessen, beträgt beispielsweise 3 mm. Die Breite des Bandes 16 und der Spuren 18 sind in der Zeichnung nur schematisch und nicht maßstabsgetreu wiedergegeben.

Die in den Spuren 18 aufgebrachten magnetischen Informationen werden durch einen Magnetfeldsensor 20 gelesen. Im dargestellten Ausführungsbeispiel sind jeder Spur 18 jeweils ein Magnetfeld-Sensor 20 zugeordnet. Die Magnetfeld-Sensoren 20 sind in einem Lesekopf 22 an einem Stator angeordnet. Die Signale des Lesekopfes 22 werden einer elektronischen Auswerte-Einheit zugeführt.

## Patentansprüche

1. Gerät zur Bestimmung eines drehwinkelabhängigen Meßwertes, mit einem trommelförmigen Rotor (12), mit einer auf der Mantelfläche des Rotors (12) angeordneten Schicht (14) eines magnetischen Mediums hoher Koerzitivkraft, die zur Aufzeichnung magnetischer Winkelinformationen in wenigstens einer ringförmig in Umfangsrichtung des Rotors (12) verlaufenden Spur (18) dient, und mit wenigstens einem an einem Stator angeordneten Magnetfeld-Sensor (20), der zum Lesen der magnetischen Winkelinformationen dient, dadurch gekennzeichnet, daß die Schicht (14) des magnetischen Mediums durch ein Band (16) oder einen Draht aus einem magnetischen Werkstoff gebildet ist, wobei das Band (16) oder der Draht schraubenlinienförmig auf die Mantelfläche des Rotors (12) gewickelt ist und wobei die Windungen so dicht aneinander anliegen, daß die axiale Spurbreite der Winkelinformationen wesentlich größer ist als die axiale Breite der Berührungsfuge zwischen den Windungen.

2. Gerät nach Anspruch 1, dadurch gekennzeichnet, daß das Band (16) oder der Draht in wenigstens zwei gegenläufig gewickelten Lagen aufgebracht ist.

3. Gerät nach Anspruch 1 oder 2, dadurch gekennzeichnet, daß die axiale Breite der Spuren (18) der Winkelinformationen ein mehrfaches der axialen Breite der Berührungsfuge der aneinander anliegenden Windungen des Bandes (16) oder des Drahtes beträgt.

## Claims

1. Apparatus for determining an angle-of-rotation-dependent measurement, having a drum-type rotor (12), having a layer (14) of a magnetic medium of high coercive force which is disposed on the circumferential surface of the rotor (12) and which serves to record magnetic angular information in at least one track (18) extending annularly in the circumferential direction of the rotor (12), and having at least one magnetic field sensor (20) which is disposed on a stator and which serves to read the magnetic angular information, characterized in that the layer (14) of the magnetic medium is formed by a strip (16) or a wire of a magnetic material, the strip (16) or the wire being wound in helical fashion onto the circumferential surface of the rotor (12) and the turns being so closely adjacent to one another that the axial track width of the angular information is substantially greater than the axial width of the contact gap between the turns.

2. Apparatus according to Claim 1, characterized in that the strip (16) or the wire is applied in at least two oppositely wound layers.

3. Apparatus according to Claim 1 or 2, characterized in that the axial width of the tracks (18) of the angular information is a multiple of the axial width of the contact gap between the turns of the strip (16) or of the wire which are adjacent to one another.

## Revendications

1. Dispositif pour déterminer une valeur de mesure dépendant d'une vitesse angulaire à l'aide d'un rotor (12) en forme de tambour, d'une couche (14) prévue sur la surface enveloppe du rotor (12) d'un milieu magnétique à force coercitive élevée servant à l'enregistrement d'informations angulaires magnétiques dans au moins une piste (18) annulaire dans la direction périphérique du rotor (12) et d'au moins un capteur de champ magnétique (20) prévu sur un stator, servant à la lecture des informations angulaires magnétiques,
caractérisé en ce que
la couche (14) du milieu magnétique est formée par un ruban (16) ou un fil de matière magnétique, le ruban (16) ou le fil étant enroulé en hélice sur la surface enveloppe du rotor (12) et les spires sont jointives pour que la largeur axiale de la piste pour les informations angulaires (1) soit nettement supérieure à la largeur axiale du joint de contact entre les spires.

2. Dispositif selon la revendication 1,
caractérisé en ce que
le ruban (16) ou le fil est prévu sur au moins deux couches enroulées en sens opposé.

3. Dispositif selon la revendication 1 ou 2,
caractérisé en ce que
la largeur axiale des pistes (18) pour les informations d'angle correspond à un multiple de la largeur axiale du joint de contact des spires jointives de la bande (16) ou du fil.
